# EUROPÄISCHE PATENTSCHRIFT

(11) **EP 1 866 654 B1**
(45) Veröffentlichungstag und Bekanntmachung des Hinweises auf die Patenterteilung: **20.06.2012**
(21) Anmeldenummer: 06723874.1
(22) Anmeldetag: 30.03.2006
(51) Int. Cl.: G01R 1/04

(54) **VORRICHTUNG UND VERFAHREN ZUM TEMPERIEREN EINES SUBSTRATS**
METHOD AND DEVICE FOR TEMPERING A SUBSTRATE
PROCEDE ET DISPOSITIF POUR TEMPÉRER UN SUBSTRAT

(30) Priorität: 30.03.2005 DE 102005014513
(43) Veröffentlichungstag der Anmeldung: 19.12.2007
(73) Patentinhaber: ATT Advanced Temperature Test Systems GmbH, 82152 Martinsried (DE)
(72) Erfinder: EIBL, Markus, 81375 München (DE)
(74) Vertreter: Müller-Boré & Partner Patentanwälte
(86) Internationale Anmeldenummer: PCT/EP2006/002908
(87) Internationale Veröffentlichungsnummer: WO 2006/103073

(56) Entgegenhaltungen:
- EP-A- 0 511 928
- US-A- 5 539 617
- US-A- 5 929 518
- US-A1- 2002 145 439
- US-B1- 6 717 115

## Beschreibung

Die Erfindung betrifft eine Vorrichtung und ein Verfahren zum Temperieren eines Substrats sowie ein Verfahren zur Herstellung einer solchen Vorrichtung.

Eine Substrathaltevorrichtung insbesondere zum Testen von Schaltungsanordnungen auf scheibenförmigen Substraten ist aus DE 101 22 036 A1 bekannt. Die darin beschriebene Vorrichtung weist eine Oberfläche zur Aufnahme eines zu testenden Substrats auf und ist als einstückiger Keramikkörper mit unterschiedlich stark dotierten Schichten ausgebildet. Insbesondere kann die Vorrichtung mit einem dotierten Schichtbereich innerhalb des Keramikkörpers ausgestaltet sein, der als Heizung dient. Damit ist eine Messung des Substrats bei höheren Temperaturen möglich. Ein Kühlen des Substrats ist dieser Vorrichtung nicht vorgesehen. Dazu muss die Haltevorrichtung mit einem herkömmlichen Thermochuck kombiniert werden.

Neben einer elektrischen Heizung weist eine aus US 5 610 529 B bekannte Substrathaltevorrichtung auch elektrische Kühlelemente auf. Solche elektrische Heiz- und Kühlelemente verursachen stets auch elektrische Störsignale, die elektrische Messungen an dem zu temperierenden Substrat beeinflussen können. Zur Abschirmung von elektrischen Störsignalen weist der Aufbau zwischen einer Substratauflagefläche und den Heiz- und Kühlelementen ein Schichtsystem aus elektrisch leitfähigen und isolierenden Bereichen auf.

Eine Kühlung in einer Substrathaltevorrichtung, bei der solche elektrische Störeffekte vermieden werden, ist aus US 6 188 563 B1 bekannt. Darin ist eine Haltevorrichtung bestehend aus einem Keramikkörper offenbart, in dem Kühlkanäle ausgebildet sind, durch die ein Kühlfluid geleitet werden kann, das eine Kühlung des Substrats bewirkt. Eine Ausgestaltung dieser Kühlkanäle im Keramikkörper, die zu einer homogenen Temperaturverteilung führt, ist allerdings schwierig. Für viele Anwendungen eine homogene Temperaturverteilung, die außerdem noch in einem weiten Temperaturbereich geregelt werden kann, aber besonders wichtig.

US 5 539 617 A beschreibt ein flüssiggekühltes Element zum Kühlen von scheibenförmigen Komponenten. Das Kühlelement umfasst einen Hauptkörper, der mit zumindest einer Kühlplatte versehen ist. Die Kühlplatte weist einen Kühlkanal in Form einer Doppelspirale auf, dessen Enden jeweils in einer Sammelkammer münden. Im Hauptkörper sind Ein- und Auslasskanäle ausgebildet, die jeweils über eine Durchlassbohrung mit einer der Sammelkammern verbunden sind und einen kontinuierlichen Durchfluss von Kühlflüssigkeit ermöglichen.

US 5 929 518 A beschreibt eine Schaltungsplatine und ein Verfahren zum Transportieren eines leitfähigen Mediums durch die Schaltungsplatine zum Betreiben einer Halbleitervorrichtung an einer Oberfläche der Schaltungsplatine. Dazu ist in der Schaltungsplatine ein Hohlraum nach Art eines Kanals ausgebildet, das abschnittsweise parallel zur Oberfläche verläuft. Als leitfähiges Medium kann darin eine Kühlflüssigkeit transportiert werden.

US 2002/0145439 A1 offenbart ein kombiniertes Heiz- und Kühlaggregat bei welchem Heizoberflächen und Kühloberflächen koplanar innerhalb des Aggregats angeordnet sind, um heiße und kalte Kontaktstellen für ein Testobjekt bereitzustellen. Einerseits sind die Heizoberflächen und die Kühloberflächen thermisch isoliert, andererseits ist der thermische Widerstand der Kühloberflächen zwischen dem Testobjekt und dem Kühlmittel gering., um so eine gute Wärmezu-und -abfuhr zu gewährleisten.

EP 0 511 928 A1 beschreibt eine Kühlvorrichtung für Halbleiterscheiben, bei dem die Halbleiterscheibe mittels Aufbringen eines Vakuums abdichtend auf Kühlkanäle gepresst wird. Die Kühlkanäle sind bevorzugt aus Kupfer und sind als doppelte gegenläufige Spiralen ausgebildet.

Es ist daher eine Aufgabe der vorliegenden Erfindung, eine Vorrichtung und ein Verfahren zum Temperieren von Substraten, die eine Regelung der Temperatur zum Kühlen und/oder zum Heizen des Substrats bei einer hohen Homogenität der Temperaturverteilung ermöglichen, sowie ein Verfahren zur Herstellung einer solchen Vorrichtung zum Temperieren von Substraten bereitzustellen.

Die Aufgabe wird gelöst durch eine Vorrichtung und ein Verfahren zum Temperieren eines Substrats sowie ein Verfahren zur Herstellung einer solchen Vorrichtung mit den in den Ansprüchen 1, 13 bzw. 18 aufgeführten Merkmalen. Bevorzugte Ausführungsformen sind Gegenstand der abhängigen Ansprüche.

Somit wird gemäß der vorliegenden Erfindung eine Vorrichtung zum Temperieren eines Substrats bereitgestellt, welche umfasst:
- ein erstes Teilelement, das eine Anlagefläche zum Anliegen an das Substrat sowie eine erste Verbindungsfläche aufweist und
- ein zweites Teilelement, das eine zweite Verbindungsfläche aufweist, über die es zumindest teilweise an der ersten Verbindungsfläche des ersten Teilelements mittelbar oder unmittelbar anliegt,
wobei zumindest eines der beiden Teilelemente Keramikmaterial umfasst,
zumindest in einer der beiden Verbindungsflächen zumindest eine Ausnehmung vorgesehen ist, die zumindest einen Hohlraum in der Vorrichtung definiert, und
zumindest eine erste Anschlussöffnung vorgesehen ist, über die ein Temperierfluidzu- und/oder -abfluss zu und/oder von dem zumindest einen Hohlraum ermöglicht wird.

Mit der erfindungsgemäßen Vorrichtung steht somit eine integrale Vorrichtung zum Temperieren eines Substrats durch ein Temperierfluid, das über die Anschlussöffnung in den Hohlraum der Vorrichtung eingeleitet bzw. aus dem Hohlraum herausgeführt werden kann. Insbesondere sind durch den zweiteiligen Aufbau der Vorrichtung vielfältige und der jeweiligen Anwendung angepasste Ausgestaltungen des Hohlraums möglich, der zwischen den beiden Teilelementen angeordnet bzw. an bzw. bei der Grenzfläche vorgesehen ist. Dadurch wird eine homogene Temperaturverteilung sowie eine gute thermische Ankopplung des Temperierfluids an die Vorrichtung ermöglicht. Außerdem erhöht die Verwendung von Keramikmaterial die Temperaturbeständigkeit.

Vorzugsweise bestehen die beiden Teilelemente im wesentlichen aus Keramikmaterial, d.h. sie umfassen zumindest einen Keramikkern oder einen Elementkörper auf Keramikmaterial (z.B. Aluminiumoxid oder Aluminiumnitrid), der den wesentlichen Bestandteil bzw. den Hauptbestandteil der Teilelemente bildet. Dabei stellt der Hauptbestandteil den im wesentlichen formgebenden Teil der Teilelemente dar.

Vorzugsweise ist in der Vorrichtung zusätzlich zur ersten zumindest eine zweite Anschlussöffnung vorgesehen, über die ein Fluidab- und/oder -zufluss von und/oder zu dem zumindest einen Hohlraum ermöglicht wird. Außerdem bildet der Hohlraum vorzugsweise zumindest einen zusammenhängenden Kanal zwischen der ersten und der zweiten Anschlussöffnung. Damit wird ein kontinuierlicher Durchfluss des Temperierfluids ermöglicht, wobei eine Anschlussöffnung als Zu-und die andere als Abfluss für das Fluid dient. Dadurch wird über eine Steuerung bzw. Regelung der Temperatur und/oder einer Menge bzw. Flussrate des zufließenden Fluids die Steuerung bzw. Regelung der Substrattemperatur erleichtert.

Vorzugsweise verläuft der zumindest eine zusammenhängende Kanal im wesentlichen mäanderförmig, d.h. er weist vorzugsweise Schlingen, auf in denen er lokal seinen Verlauf im wesentlichen umkehrt. Dies verbessert zum einen die thermische Ankopplung des Temperierfluid an die Vorrichtung und zum anderen die Homogenität der Temperaturverteilung.

Weiter bevorzugt ist der zusammenhängende Kanal derart angeordnet, dass ein Fluiddurchfluss von der ersten Anschlussöffnung durch den Kanal zur zweiten Anschlussöffnung im wesentlichen im Gegenstromprinzip erfolgt. Der Kanal ist also derart angeordnet, dass zumindest zu einem ersten Abschnitt des Kanals ein dazu benachbarter und im wesentlichen parallel verlaufender zweiter Abschnitt des Kanals existiert, wobei das Fluid in den beiden Kanalabschnitten in etwa entgegengesetzter Richtung fließt. Dies bewirkt, dass ein sich in Flussrichtung des Fluids aufgrund der Energieübertragung zwischen Fluid und Vorrichtung im ersten Kanalabschnitt ausbildender Temperaturgradient einem aufgrund der entgegengesetzten Flussrichtung etwa entgegengesetzten Temperaturgradienten im benachbarten zweiten Kanalabschnitt gegenüber steht. Damit wird eine verbesserte Temperaturhomogenität an der Anlagefläche für das Substrat erreicht. Besonders bevorzugt ist dabei, wenn bereits zwei Anschlussöffnungen des selben Kanals benachbart sind und die Kanalabschnitte von den Anschlussöffnungen an durch die gesamte Vorrichtung mäanderförmig im wesentlichen parallel zueinander verlaufen.

Vorzugsweise sind im Kanal Rippen ausgebildet sind, deren Längsrichtung im wesentlichen in Richtung des Kanals verlaufen. Dies bewirkt eine große Oberfläche im Kanalbereich und damit eine gute thermische Ankopplung des Temperierfluids an die Vorrichtung.

Vorzugsweise ist in beiden Teilelementen jeweils zumindest eine Ausnehmung vorgesehen, die zusammen den zumindest einen Hohlraum bilden. Besonders bevorzugt liegen die Verbindungsflächen im wesentlichen in einer Verbindungsebene, wobei die Ausnehmungen in den beiden Teilelementen symmetrisch bezüglich der Verbindungsebene ausgebildet sind. Eine symmetrische Ausgestaltung der beiden Teilelemente ist besonders Vorteilhaft für die Herstellung von keramischen Teilelementen, da eine Anpassung der Teilelemente aneinander auch nach einem eventuellen Schrumpfen der Teilelemente beim Brennen der Keramik weitgehend erhalten bleibt. Außerdem bewirkt eine symmetrische Ausgestaltung der Teilelemente ein im wesentlichen gleiches thermisches Ausdehnungsverhalten.

Vorzugsweise sind die Teilelemente an den Verbindungsflächen derart fluiddicht miteinander verbunden, dass ein Austritt eines Fluids aus dem Hohlraum im wesentlichen nur über die zumindest eine Anschlussöffnung möglich ist.

Gemäß einem Aspekt der Erfindung ist zumindest an einer der beiden Verbindungsflächen eine Verbindungsschicht angeordnet. Diese erleichtert unter anderem die Abdichtung der Verbindungsflächen und/oder die Haftung der Teilelemente aneinander. Besonders bevorzugt ist dabei, wenn die zumindest eine Verbindungsschicht zumindest teilweise zu einer elektrisch leitfähigen Schicht ausgestaltet ist, die vorzugsweise Nickel oder Kupfer umfasst. Durch diese elektrisch leitfähige Schicht lassen sich elektrische Störsignale abschirmen, was besonders für elektrische Messungen am zu temperierenden Substrat wünschenwert ist. Am meisten bevorzugt ist, wenn dazu die leitfähige Verbindungsschicht über die Verbindungsfläche hinausragt, um einen elektrischen Anschlusskontakt auszubilden, der insbesondere von außerhalb der Vorrichtung zugänglich ist.

An der Anlagefläche des ersten Teilelements ist vorzugsweise zumindest teilweise bzw. bereichsweise eine elektrisch leitfähige erste Abschirmschicht angeordnet. Diese erste Abschirmschicht ermöglicht zusätzlich oder alternativ zu einer elektrisch leitfähigen Verbindungschicht die Abschirmung von elektrischen Störsignalen. Sie könnte aber auch mit dem Substrat elektrisch leitfähig verbindbar sein, um damit das Substrat auf ein bestimmtes elektrisches Potential zu bringen. Besonders bevorzugt weist diese erste Abschimschicht zumindest einen elektrischen Anschlusskontakt auf.

Vorzugsweise weist das zweite Teilelement zusätzlich eine Aussenfläche bzw. Montagefläche auf, an der zumindest bereichsweise eine elektrisch leitfähige zweite Abschirmschicht angeordnet ist. Besonders bevorzugt ist diese Außenfläche bzw. Montagefläche eine der Verbindungsfläche abgewandte und dazu planparallele Fläche. Die zweite Abschimschicht könnte, wie die erste Abschirmschicht oder die Verbindungsschicht eine Abschirmung von elektrischen Störsignalen bewirken und vorzugsweise einen elektrischen Anschlusskontakt aufweisen.

Besonders bevorzugt ist die gleichzeitige Ausgestaltung der Temperiervorrichtung mit der elektrisch leitfähigen Verbindungsschicht und der ersten und zweiten elektrisch leitfähigen Abschirmschicht. Damit lässt sich vorteilhafterweise eine Triax-Schaltung der drei Schichten bewirken, wobei die erste Abschirmschicht mit Force-Potential, die elektrisch leitfähige Verbindungsschicht mit Guard-Potential und die zweite Abschirmschicht mit Shield- bzw. Ground-Potential verbunden wird bzw. werden kann. Dies bewirkt eine besonders gute Abschirmung von elektrischen Störsignalen und erlaubt damit hochsensible rauschfreie elektrische Messungen am Substrat.

Vorzugsweise ist an der Aussenfläche bzw. Montagefläche des zweiten Teilelements ein integriertes Heizelement angeordnet und/oder ein externes Heizelement anbringbar. Insbesondere in der Kombination eines Kühlfluids mit einem Heizelement ist eine schnelle und vorteilhaft präzise Temperaturregelung bzw. -steuerung möglich. Außerdem kann die Vorrichtung mit herkömmlichen Thermochucks oder Heizplatten (hot plates) verwendbar sein.

Das erste Teilelement ist vorzugsweise zylinderförmig ausgestaltet, wobei die erste Verbindungsfläche und die Anlagefläche planparallele Basisflächen bilden.

Ausserdem wird gemäß der vorliegenden Erfindung ein Verfahren zur Herstellung einer Vorrichtung zum Temperieren eines Substrats bereitgestellt, welches folgende Schritte in dieser Reihenfolge umfasst:
(a) Bereitstellen eines ersten Teilelements mit einer Anlagefläche und einer ersten Verbindungsfläche und eines zweiten Teilelements mit einer zweiten Verbindungsfläche, wobei zumindest eines der beiden Teilelemente Keramikmaterial umfasst;
(b) Ausbilden zumindest einer Ausnehmung in zumindest einer der beiden Verbindungsflächen;
(c) Verbinden der ersten Verbindungsfläche des ersten Teilelements mit der zweiten Verbindungfläche des zweiten Teilelements derart, dass die Ausnehmung einen Hohlraum in der Vorrichtung bildet.

Die erfindungsgemäße Herstellung einer Vorrichtung zum Temperieren eines Substrats aus zwei Teilelementen vereinfacht die Ausgestaltung der zumindest einen Ausnehmung, die nach dem Verbinden der Teilelemente den Hohlraum formt, wodurch eine besonders individuelle und dem Problem angepasste Gestaltung des Hohlraums vorgenommen werden kann. Außerdem erhöht die Verwendung von Keramikmaterial die Temperaturbeständigkeit bzw. Ermöglicht höhere Temperaturen und/oder führt zu einer höheren Festigkeit..

Vorzugsweise umfasst der Schritt (c) des Verbindens der beiden Teilelemente einen Schritt des Hartlötens.

Vorzugsweise umfasst der Schritt (a) des Bereitstellens des ersten und zweiten Teilelements einen Schritt des Formens des ersten und/oder zweiten Teilelements als einen ersten und/oder einen zweiten Grünling aus Keramikmaterial. Dabei wird vorzugsweise ein Grünling aus Keramikrohmaterial, das vorzugsweise eine keramische Pulvermischung umfasst, in einer Form hergestellt, die durch die gewünschte endgültige Form des ersten und/oder zweiten Teilelements unter Berücksichtigung der sich in den folgenden Verfahrenschritten ergebenden Formänderung bestimmt wird. Somit wird vorzugsweise ein erster und/oder ein zweiter Grünling hergestellt, der eine erste bzw. eine zweite Verbindungsfläche aufweist.

Vorzugsweise umfasst das Verfahren zusätzlich einen Schritt des Brennens des ersten und/oder zweiten Grünlings. Dadurch entsteht aus dem vorzugsweise relativ leicht verformbaren Grünling ein (vorzugsweise sehr viel) härteres erstes und/oder zweites Teilelement. Dies erfolgt vorzugsweise durch einen Sinterprozess, den der Schritt des Brennens vorzugsweise umfasst und in dem bei hohen Temperaturen aus dem Keramikrohmaterial geringer Festigkeit mechanisch festeres Keramikmaterial entsteht.

Vorzugsweise erfolgt der Schritt (b) des Ausbildens der zumindest einen Ausnehmung vor dem Schritt des Brennens des entsprechenden Teilelements, in dem die Ausnehmung ausgebildet wird. Im nicht gebrannten Zustand, d.h. im Grünzustand, kann eine mechanische Bearbeitung des entsprechenden Teilelements leichter durchgeführt werden als im gebrannten, also ausgehärteten Zustand. Vorzugsweise erfolgt nach dem Brennen eine Nachbearbeitung, um Korrekturen insbesondere von durch Verformung des Teilelements beim Brennen entstandener Fehler vorzunehmen. Typischerweise schrumpfen solche Teilelemente vom Grünzustand zum gebrannten Zustand um 20% bis 30%. Dieses Schrumpfen kann evtl. ungleichmäßig erfolgen.

Vorzugsweise umfasst das Verfahren zusätzlich einen Schritt des Ausbildens zumindest einer ersten elektrisch leitfähigen Abschirmschicht an der Anlagefläche des ersten Teilelements und/oder einer zweiten elektrisch leitfähigen Abschimschicht an einer Außenfläche des zweiten Teilelements. Vorzugsweise umfasst das Ausbilden der ersten und/oder zweiten Abschimschicht einen Schritt des Sputterns und/oder Aufdampfens von elektrisch leitfähigen Material, das vorzugsweise Metall umfasst. Weiter bevorzugt erfolgt der Schritt des Ausbildens der ersten und/oder zweiten Abschirmschicht nach einem Schritt des Brennens des entsprechenden Teilelements. Die zumindest eine Abschirmschicht könnte dabei vor oder nach dem Schritt (c) des Verbindens der beiden Teilelemente ausgebildet werden.

Außerdem umfasst das Verfahren (vorzugsweise vor dem Schritt (c) des Verbindens der beiden Teilelemente) einen zusätzlichen Schritt des Abscheidens einer elektrisch leitfähigen Schicht auf zumindest einem Teil bzw. Bereich zumindest einer der beiden Verbindungsflächen. Besonders bevorzugt erfolgt dieser Schritt nach dem Schritt (b) des Ausbildens der zumindest einen Ausnehmnung. Die zumindest eine leitfähige Schicht wird vorzugsweise als Teil einer Verbindungsschicht ausgebildet, über die die beiden Teilelemente im Schritt (c) verbunden werden. Der Schritt des Abscheidens dieser zumindest einen leitfähigen Schicht umfasst vorzugsweise einen Schritt des Sputterns und/oder Aufdampfens von elektrisch leitfähigem Material, das vorzugsweise Metall umfasst. Vorzugsweise bildet diese Schicht eine im wesentlichen geschlossene, zusammenhängende Schicht, die besonders bevorzugt an der gesamten zumindest einen Verbindungsfläche angeordnet ist.

Gemäß der vorliegenden Erfindung wird außerdem ein Verfahren zum Temperieren eines Substrats bereitgestellt, welches folgende Schritte umfasst:
- Bereitstellen einer Vorrichtung zum Temperieren eines Substrats gemäß der vorliegenden Erfindung oder einer bevorzugten Ausführungsform;
- Anordnen des Substrats zumindest teilweise an der Anlagefläche;
- Zuführen und/oder Abführen eines Fuids zu und/oder von dem zumindest einen Hohlraum über die zumindest eine erste Anschlussöffnung.

Vorzugsweise wird dabei das Fluid über die zumindest eine erste Anschlussöffnung zu dem zumindest einen Hohlraum zugeführt und über die zumindest eine zweite Anschlussöffnung von dem zumindest einen Hohlraum abgeführt.

Besonders bevorzugt wird dabei die Temperatur und/oder die Flussrate des zugeführten Fluids zur Steuerung bzw. Regelung der Temperatur des Substrats verändert. Dabei kann die Temperatur und/oder die Flussrate des zugeführten Fluids vorzugsweise in Abhängigkeit eines Signal eines in bzw. an der Vorrichtung und/oder an dem Substrat vorgesehenen Temperatursensors geregelt werden.

Vorzugsweise wird in dem Temperierverfahren eine erfindungsgemäße Vorrichtung bereitgestellt, in deren Anlagefläche Vakuumrillen ausgebildet sind und das Temperierverfahren umfasst dabei bevorzugt zusätzlich einen Schritt des Ansaugens des Substrats mittels der Vakuumrillen.

Bevorzugt wird in dem Temperierverfahren eine Vorrichtung bereitgestellt, die an zumindest einer der beiden Verbindungsflächen eine elektrisch leitfähige Verbindungsschicht, an der Anlagefläche eine elektrisch leitfähige erste Abschirmschicht und an einer Aussenfläche des zweiten Teilelements eine elektrisch leitfähige zweite Abschirmschicht aufweist, wobei
- die erste Abschirmschicht mit Force-Potential,
- die zweite Abschirmschicht mit Shield-Potential und
- die Verbindungsschicht mit Guard-Potential elektrisch leitfähig verbunden wird.

Vorzugsweise wird in dem Temperierverfahren an einer Aussenfläche des zweiten Teilelements ein Heizelement angeordnet, wobei eine Steuerung bzw. Regelung der Temperatur des Substrats eine Steuerung bzw. Regelung der Temperatur und/oder der Heizleistung des Heizelements umfasst.

Insgesamt lassen sich vorzugsweise die erfindungsgemäße Vorrichtung und ihre bevorzugten Ausführungsformen durch das erfindungsgemäße Herstellungsverfahren herstellen. Vorzugsweise stellen außerdem die Verfahrensprodukte der bevorzugten Ausführungsformen des erfindungsgemäßen Herstellungsverfahrens bevorzugte Ausführungsformen der erfindungsgemäßen Vorrichtung dar.

Die Erfindung wird nachfolgend mit Bezug auf begleitende Zeichnungen bevorzugter Ausführungsformen beispielhaft beschrieben. Dabei zeigen:
- Fig. 1: einen Querschnitt einer ersten bevorzugten Ausführungsform einer erfindungsgemäßen Vorrichtung zum Temperieren eines Substrats.
- Fig. 2A-2C: jeweils eine Draufsicht auf die erste Verbindungsfläche des ersten Teilelements gemäß weiterer bevorzugter Ausführungsformen der erfindungsgemäßen Vorrichtung

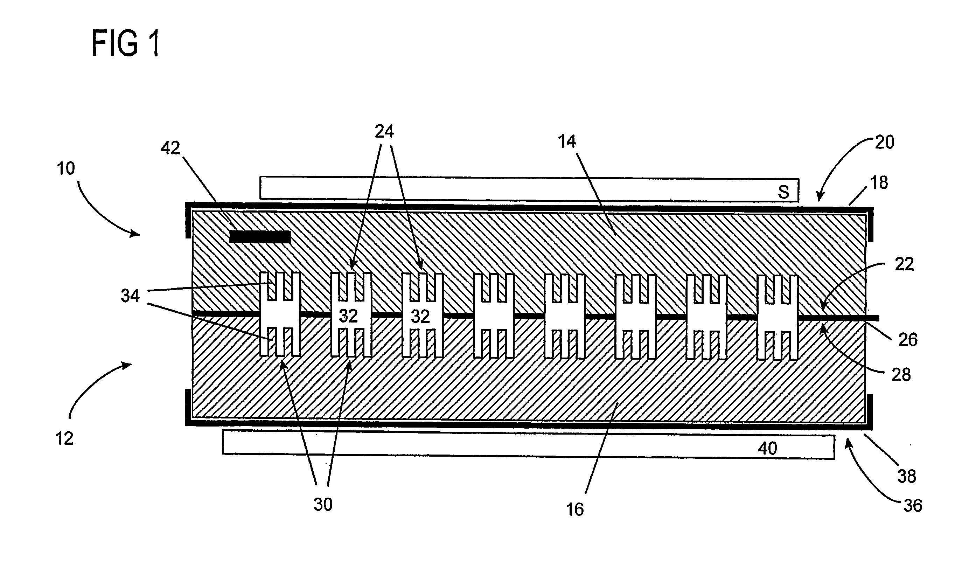

Fig. 1 zeigt einen Querschnitt einer bevorzugten Ausführungsform der erfindungsgemäßen Vorrichtung zum Temperieren eines Substrats. Darin ist ein erstes Teilelement 10 und ein zweites Teilelement 12 gezeigt, die jeweils einen vorzugsweise im wesentlichen zylinderförmigen ersten Keramikkörper 14 bzw. zweiten Keramikkörper 16 umfassen. Als Keramikmaterial hierfür eignet sich z.B. Aluminiumoxid oder Aluminiumnitrid. An einer im wesentlichen planaren, (bevorzugt kreisförmigen) Basisfläche des ersten Keramikkörpers 14 ist eine elektrisch leitfähige erste Abschirmschicht 18 vorgesehen, welche eine Anlagefläche 20 des ersten Teilelements 10 bildet. Zum Temperieren eines Substrats S (z.B. Halbleiterwafer) wird dieses mit der Anlagefläche 20 zumindest bereichsweise in Kontakt gebracht. Dabei steht das Substrat S vorzugsweise in flächigem Kontakt zur Anlagefläche 20.

Die erste Abschirmschicht 18 umfasst vorzugsweise Metall (z.B. Gold oder Nickel) und weist eine Schichtdicke in Normalenrichtung zur Anlagefläche 20 auf, die in einem Bereich von etwa 1 µm bis einige 10 µm liegt. In der gezeigten Ausführungsform ragt die erste Abschirmschicht 18 über die Anlagefläche 20 hinaus und bedeckt nicht nur die planare Fläche des ersten Keramikkörpers 14 sondern weist außerdem Randbereiche auf, die dessen zylindrische Mantelfläche zumindest teilweise bedecken. Neben einer zusätzlichen elektrischen Abschirmwirkung können diese Randbereiche auch als elektrische Anschlüsse dienen. Somit weist die elektrisch leitfähige erste Abschirmschicht 18 vorzugsweise zumindest einen über die Anlagefläche 20 hinausragenden und mit der an der Anlagefläche 20 angeordneten ersten Abschirmschicht 18 elektrisch leitfähig verbundenen Kontaktierungsbereich auf. Vorzugsweise sind in bzw. an der Anlagefläche Vakuumrillen zum Ansaugen des Substrats S ausgebildet.

Außerdem weist das erste Teilelement 10 eine der Anlagefläche 20 im wesentlichen abgewandte und zu dieser planparallele erste Verbindungsfläche 22 auf. In der ersten Verbindungsfläche 22 des ersten Teilelements 10 sind erste Ausnehmungen bzw. Aussparungen 24 vorgesehen. Außerdem ist an der ersten Verbindungsfläche 22 eine elektrisch leitfähige Verbindungsschicht 26 angeordnet. Die Verbindungsschicht 26 ist im Bereich der ersten Ausnehmungen 24 unterbrochen. Vorzugsweise könnten aber auch die Grenzflächen bzw. Oberflächen der ersten Ausnehmungen 24 mit einer elektrisch leitfähigen Schicht überzogen sein, die zusammen mit der Verbindungsschicht 26 eine geschlossene elektrisch leitfähige Schicht bildet. Die elektrisch leitfähige Verbindungsschicht 26 ragt vorzugsweise über die erste Verbindungsfläche hinaus bzw. ist derart ausgebildet, um einen elektrischen Anschlusskontakt auszubilden.

Das zweite Teilelement 12 weist eine im wesentlichen planare zweite Verbindungsfläche 28 auf, über die es an die erste Verbindungsfläche 22 des ersten Teilelements 10 angeordnet und mit diesem verbunden bzw. verbindbar ist (mittelbar/unmittelbar). Dabei umfasst die Verbindungsschicht 26 vorzugsweise Kupfer oder Nickel und verbindet durch Hartlöten die beiden Teilelemente miteinander.

In der zweiten Verbindungsfläche 28 des zweiten Teilelements 12 sind zweite Ausnehmungen 30 derart ausgebildet, dass sie zusammen mit den ersten Ausnehmungen 24 im ersten Teilelement 10 Hohlräume 32 bilden. Wie an den Grenzflächen bzw. Oberflächen der ersten Ausnehmungen 24 könnte alternativ oder zusätzlich an den Grenzflächen bzw. Oberflächen der zweiten Ausnehmungen 30 zumindest eine leitfähige Schicht angeordnet sein, die zusammen mit der Verbindungschicht 26 eine geschlossene elektrisch leitfähige Schicht bildet. In den Ausnehmungen 24, 30 sind eine oder mehrere Rippen 34 ausgebildet, die in die Hohlräume 32 ragen, um die Oberflächen der Ausnehmungen 24, 30 zu vergrößern, die als Kontaktflächen zu einem Temperierfluid dienen. Damit wird der Energietransfer zwischen Temperierfluid und Temperiervorrichtung verbessert. Die gute thermische Ankopplung des Temperierfluids an die Vorrichtung ist für eine schnelle und/oder präzise Temperaturregelung bzw. -steuerung besonders vorteilhaft.

Die zweiten Ausnehmungen 30 sind bezüglich der Verbindungsflächen bevorzugt im wesentlichen symmetrisch bzw. spiegelsymmetrisch zu den ersten Ausnehmungen 24 angeordnet. Vorzugsweise ist das gesamte zweite Teilelement 12 im wesentlichen symmetrisch bzw. spiegelsymmetrisch zum ersten Teilelement 10 ausgebildet. Insbesondere sind die Keramikkörper 14, 16 im wesentlichen symmetrisch zueinander ausgebildet. Dies erleichtert bei der Herstellung der Temperiervorrichtung insbesondere die Anpassung der beiden Teilelemente.

Das zweite Teilelement 12 weist außerdem eine Außenfläche bzw. Montagefläche 36 auf, an der eine elektrische leitfähige zweite Abschirmschicht 38 angeordnet bzw. anordenbar ist. Die zweite Abschirmschicht 38 ist vorzugsweise analog zur ersten Abschirmschicht 18 ausgestaltet. Vorzugsweise ist an der Außenfläche 36 ein Heizelement 40 angeordnet. Das Heizelement 40 kann entweder fest mit der Außenfläche 36 verbunden sein oder lösbar an die Außenfläche 36 -angeordnet sein. Mit Hilfe dieses Heizelements 40 kann zusätzlich die Regelung bzw. Steuerung der Temperatur unterstützt werden. Um eine genaue Regelung der Temperatur zu ermöglichen, weist das erste Teilelement 10 bzw. untere Teil einen Temperatursensor 42 auf, der vorzugsweise durch einen Thermowiderstand (z.B. PT100) gebildet wird.

In einer bevorzugten Ausführungsform des erfindungsgemäßen Verfahrens zum Temperieren eines Substrats werden die in Fig. 1 dargestellten elektrisch leitfähigen Abschirmschichten 18, 38 und die elektrisch leitfähige Verbindungsschicht 26 in einer triaxialen Verschaltung jeweils mit elektrischen Potentialen beaufschlagt. Dazu werden sie an seitlich ausgebildeten Kontakten elektrisch leitfähig verbunden. Dabei wird bevorzugt die erste Abschirmschicht 18 mit Force-Potenfial, die Verbindungsschicht 26 mit Guard-Potential und die zweite Abschirmschicht 38 mit Shield- bzw. Ground-Potential verbunden. Zum Temperieren des Substrats S wird vorzugsweise ein Temperierfluid (d.h. ein Kühl- bzw. Heizfluid) in die Hohlräume 32 eingeführt, wobei eine Aufheizung bzw. eine genauere Temperaturregelung bevorzugt über das Heizelement 40 erfolgt. Alternativ könnte auch durch ein Heizfluid die Temperatur des Substrats erhöht werden, ohne dass dazu das Heizelement 40 notwendig ist.

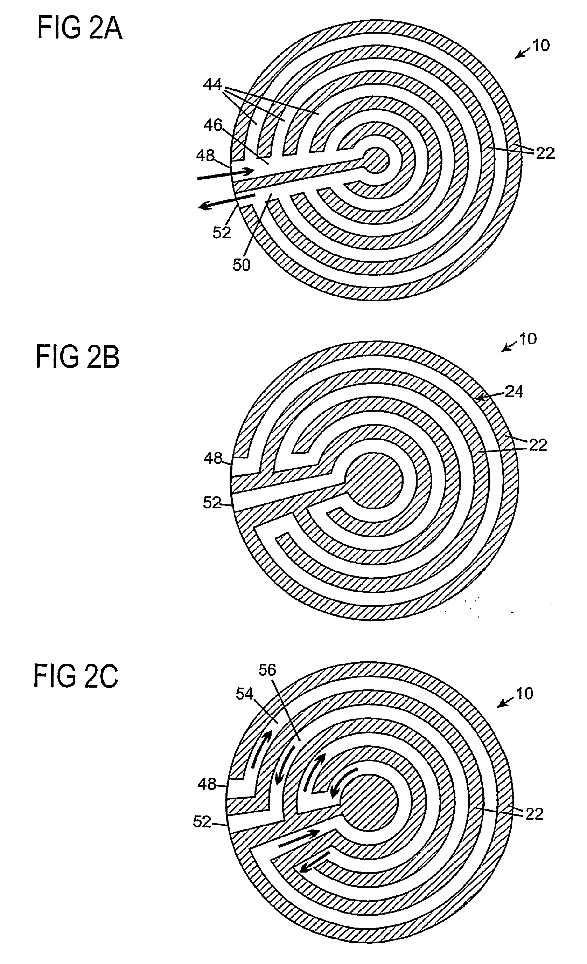

Die Figs. 2 zeigen bevorzugte Ausgestaltungen der ersten Ausnehmungen 24 in einer Draufsicht auf die ersten Verbindungsfläche 22 des ersten Teilelements 10.

In Fig. 2A sind die Hohlräume 32 zu einer Vielzahl von ringförmigen Kanälen 44 ausgebildet, die über einen im wesentlichen radial verlaufenden Zuflusskanal 46 mit einer ersten Anschlussöffnung 50 und über einen im wesentlichen radial verlaufenden Abflusskanal 48 mit einer zweiten Anschlussöffnung 52 verbunden sind. Ein durch die erste Anschussöffnung 50 eingeführtes Temperierfluid kann sich somit über den Zuflusskanal 46 auf die ringförmigen Kanäle 44 verteilen und kann über den Abflusskanal 48 durch die zweite Anschlussöffnung 52 wieder aus der Vorrichtung geleitet werden. Damit erreicht man einen im wesentlichen kontinuierlichen Fluss des Temperierfluid. Insbesondere kann das durch die zweite Anschlussöffnung 52 austretende Fluid wieder durch die erste Anschlussöffnung 50 in die Vorrichtung zurückgeführt werden, nachdem es durch eine externe Heizung bzw. Kühlung auf eine gewünschte Temperatur gebracht wurde. Diese Temperatur kann beispielsweise in Abhängigkeit eines Signals vom Temperatursensor 42 geregelt werden. In dieser Ausführungform ist es besonders bevorzugt, wenn der Durchflussquerschnitt der einzelnen ringförmigen Kanäle 44 individuell an ihre Länge angepasst wird. So kann beispielsweise ein größerer Durchflussquerschnitt der äußeren ringförmigen Kanäle zu einer Vergrößerung der Durchflussgeschwindigkeit und damit zu einer Angleichung der Durchflusszeiten des Fluids durch die einzelnen ringförmigen Kanäle führen. Besonders bevorzugt ist, wenn die mittlere Durchflusszeit in allen Kanälen im wesentlichen gleich groß ist. Damit kann man eine höhere Homogenität der Temperaturverteilung erreichen.

Fig. 2B zeigt eine weitere bevorzugte Ausführungsform der Hohlräume 32. Diese sind zu einem einfach zusammenhängenden, also nicht verzweigten Kanal ausgebildet, der im wesentlichen mäanderförmig verläuft.

Fig. 2C zeigt ebenfalls einen im wesentlichen mäanderförmigen Verlauf eines einfach zusammenhängenden Kanals. Insbesondere ist dieser Kanal im Gegenstromprinzip ausgelegt, d.h. zu jedem ersten Kanalabschnitt 54 gibt es einen benachbarten und im wesentlichen dazu parallel verlaufenden zweiten Kanalabschnitt 56, in dem das Temperierfluids im wesentlichen entgegengesetzt zu der Richtung im ersten Kanalabschnitt 54 fließt. Dadurch ist einem Temperaturgradienten im ersten Kanalabschnitt 54, der durch eine Energieaufnahme bzw. Abgabe des Fluids von der bzw. an die Temperiervorrichtung entsteht, ein entgegengesetzt verlaufender Temperaturgradient im zweiten Kanalabschnitt 56 benachbart. Somit lassen sich lokale Temperaturdifferenzen zwischen den Kanalabschnitten zumindest auf Distanzen, die größer sind als der Kanalabstand ausgleichen, was zu einer besonders homogenen Temperaturverteilung im Bereich der Anlagefläche 20 führt. Bei dem in Fig. 2C gezeigte Kanal, ist das Gegenstromprinzip im wesentlichen im gesamten Verlauf des Kanals realisiert.

In einer weiteren nicht gezeigten Ausführungsform weist das erste Teilelement 10 vorzugsweise einen Vakuumanschluss auf, mit Hilfe dessen über Rillen in der Anlagefläche 20 das Substrat S angesaugt werden kann. Diese Rillen weisen vorzugsweise Flankenflächen auf, die mit der Anlagefläche 20 einen Winkel einschließen der kleiner als 90° ist. Damit lässt sich beim Aufsputtern der ersten Abschirmschicht 18 eine geschlossene leitfähige Schicht erreichen. Würden die Rillen Flankenflächen aufweisen, die senkrecht zur Anlagefläche 20 verlaufen, oder würden die Flanken sogar eine überhängende Struktur aufweisen, könnte ein aus einer Richtung senkrecht zur Anlagefläche 20 aufgesputterter Metallfilm an diesen Flanken unterbrochen sein und es würden sich Bereiche der ersten Abschirmschicht 18 ausbilden, die nicht elektrisch leitend mit dem Rest der Abschirmschicht verbunden wären. Vorzugsweise könnten auch die Ausnehmungen 24, 30 eine entsprechende Flankenstruktur aufweisen, um auch im Bereich der Ausnehmungen und der Verbindungsflächen 22, 28 eine geschlossene leitfähige Schicht erreichen zu können.

Abweichend von den gezeigten bevorzugten Ausführungsformen könnte in einer weiteren nicht gezeigten bevorzugten Ausführungsform der vorliegenden Erfindung die Ausnehmungen nur in einem der beiden Teilelemente vorgesehen sein. Das andere Teilelement würde dann vorzugsweise eine durchgehende bzw. geschlossene planare Verbindungsfläche aufweisen. Außerdem könnte die erste Abschirmschicht 18 nur einen Teil der Anlagefäche 20 bilden. Die Größe und Form der Abschirmschicht könnte insbesondere an das zu temperierende Substrat S angepasst sein. Dabei könnten die verbleibenden Flächen der Anlagefläche 20 durch den ersten Keramikkörper 14 gebildet werden. Ebenso könnte die zweite Abschirmschicht 38 nur einen Teil der Außenfläche 36 bilden. Eine der leitenden Schichten (z.B. die leitende Schicht 38) kann ebenfalls als Temperaturserisor dienen, indem (ähnlich einem PT100-Sensor) die Temperaturabhängigkeit des Widerstands der Schicht zur Bestimmung der Temperatur verwendet wirt.

In einer bevorzugten Ausführungsform des erfindungsgemäßen Herstellungsverfahrens werden zunächst die Keramikkörper 14, 16 der beiden Teilelemente 10, 12 als Grünlinge in einer im wesentlichen zylindrischen Form hergestellt. In dem noch nicht ausgehärteten Zustand, also als Grünlinge, lassen sich die Keramikkörper 14, 16 noch relativ leicht formen. Daher werden bereits in diesem Zustand die Ausnehmungen 24, 30 zumindest teilweise geformt. Die Ausnehmungen könnten dabei zusammen mit der zylindrischen Form hergestellt werden. Im Anschluss daran werden die Grünlinge getrocknet und gebrannt. Dadurch erreichen die Keramikkörper im wesentlichen ihre endgültige Härte und Temperaturbeständigkeit. Beim Trocknen und Härten schrumpfen die Keramikkörper 14, 16 typischerweise um etwa 20% bis 30%. Dabei kann sich auch ihre Form leicht verändern. Bei einer symmetrischen Ausgestaltung der Keramikkörper 14, 16 ergibt sich auch eine im wesentlichen symmetrische Verformung (z.B. Schrumpfen), wodurch die Anpassung der beiden Keramikkörper zueinander weitgehend erhalten bleibt. Vorzugsweise werden die Keramikkörper 14, 16 und insbesondere deren Ausnehmungen 24, 30 nach dem Brennen (bevorzugt mechanisch) nachbearbeitet. Dabei werden vorzugsweise auch die Verbindungsflächen 22, 28 planarisiert.

Vorzugsweise werden an der Anlagefläche 20 Rillen vorgesehen, über die mittels eines Vakuums das Substrat an der Anlagefläche gehalten werden kann. Diese Rillen können bereits in den Grünlingen ausgebildet werden. Es ist aber auch eine Herstellung der Rillen im gebrannten Zustand möglich.

Danach werden auf den Keramikkörpern vorzugsweise elektrisch leitfähige Abschirmschichten 18, 38 abgeschieden. Dies erfolgt vorzugsweise durch Sputtern, Aufdampfen, insbesondere durch CVD (chemical vapour deposition), elektrolitische Abscheidung oder Auftragung (z.B. mittels eines Lösungsmittels).

Die zuvor in der Anlagefläche ausgebildeten Rillen weisen dabei vorzugsweise ein Profil auf, das sich als Querschnitt der Rillen in einer Ebene senkrecht zu deren Längsrichtung ergibt und das vorzugsweise im wesentlichen eine "V"- oder "U"-Form aufweist. Es ist auch ein andere Form des Profils der Rillen denkbar, das sich aus eine Kombination aus geraden und/oder gekrümmten Linien ergibt. Somit werden die Oberflächen der Rillen vorzugsweise durch ein Kombination aus planaren und/oder gekrümmten Flächen gebildet. Dabei schließen die Oberflächen der Rillen mit der Anlagefläche vorzugsweise einen Winkel kleiner als 90° ein. Bei einem im wesentlichen "U"-förmigen Profil bedeutet dies im wesentlichen ein Aufweitung des Querschnitts vom Rillenboden bzw. -scheitel zu dessen Rand, über den die Rillen an die Anlagefläche grenzen. Dadurch erreicht man beim Abscheiden der Abschirmschicht 18 eine geschlossene Bedeckung des Keramikkörpers im Bereich des Anlagefläche und der Rillen. Dadurch vermeidet man elektrisch nicht ankontaktierte Bereich der Abschirmschicht 18.

Die beiden Teilelemente werden schließlich vorzugsweise durch Hartlöten (brazing) miteinander verbunden. Zum Hartlöten verwendetes Kupfer bzw. Silberlot auf Nickel kann dabei gleichzeitig als elektrisch leitende Verbindungsschicht dienen, die eine Abschirmung elektrischer Störsignale bewirkt. Denkbar ist weiterhin ein co-fixing-Verfahren, bei dem die beiden Teilelemente durch Verwendung einer Glasurschicht zusammengebrannt werden, oder ebenfalls ein Kleben der beiden Teilelemente.

Dabei ist es besonders vorteilhaft, wenn die Anlageflächen derart fluiddicht miteinander verbunden werden, dass das Temperierfluid nur über die Anschlussöffnungen zu- bzw. abfließen kann und nicht in anderen Bereichen aus den Kanälen austritt.

### Bezugszeichenliste

- 10: erstes Teilelement
- 12: zweites Teilelement
- 14: erster Keramikkörper
- 16: zweiter Keramikkörper
- 18: erste Abschirmschicht
- 20: Anlagefläche
- 22: erste Verbindungsfläche
- 24: erste Ausnehmungen
- 26: Verbindungsschicht
- 28: zweite Verbindungsfläche
- 30: zweite Ausnehmungen
- 32: Hohlräume
- 34: Rippen
- 36: Aussenfläche bzw. Montagefläche
- 38: zweite Abschirmschicht
- 40: Heizelement
- 42: Temperatursensor
- 44: ringförmige Kanäle
- 46: Zuflusskanal
- 48: Abflusskanal
- 50: erste Anschlussöffnung
- 52: zweite Anschlussöffnung
- 54: erster Kanalabschnitt
- 56: zweiter Kanalabschnitt
- S: Substrat

## Patentansprüche

1. Vorrichtung zum Temperieren eines Substrats (S) umfassend:
- ein erstes Teilelement (10), das eine Anlagefläche (20) zum Anliegen an das Substrat (S) sowie eine erste Verbindungsfläche (22) aufweist und
- ein zweites Teilelement (12), das eine zweite Verbindungsfläche (28) aufweist, über die es zumindest teilweise an der ersten Verbindungsfläche (22) des ersten Teilelements (10) anliegt,
wobei zumindest eines der beiden Teilelemente (10, 12) Keramikmaterial umfasst,
zumindest in einer der beiden Verbindungsflächen (22, 28) zumindest eine Ausnehmung (24, 30) vorgesehen ist, die zumindest einen Hohlraum (32) in der Vorrichtung definiert, und
zumindest eine erste Anschlussöffnung (48) vorgesehen ist, über die ein Temperierfluidzu- und/oder -abfluss zu und/oder von dem zumindest einen Hohlraum (32) ermöglicht wird,
wobei an zumindest einer der beiden Verbindungsflächen (22, 28) eine elektrisch leitfähige Verbindungsschicht (26) angeordnet ist, die vorzugsweise Nickel oder Kupfer umfasst.

2. Vorrichtung nach Anspruch 1, wobei zusätzlich zumindest eine zweite Anschlussöffnung (52) vorgesehen ist, über die ein Fluidab- und/oder -zufluss von und/oder zu dem zumindest einen Hohlraum (32) ermöglicht wird.

3. Vorrichtung nach Anspruch 2, wobei der Hohlraum (32) zumindest einen zusammenhängenden Kanal zwischen der ersten (48) und der zweiten Anschlussöffnung (52) bildet.

4. Vorrichtung nach Anspruch 3, wobei der zumindest eine zusammenhängende Kanal im wesentlichen mäanderförmig verläuft.

5. Vorrichtung nach Anspruch 3 oder 4, wobei der zusammenhängende Kanal derart angeordnet ist, dass ein Fluiddurchfluss von der ersten Anschlussöffnung durch den Kanal zur zweiten Anschlussöffnung im wesentlichen im Gegenstromprinzip erfolgt.

6. Vorrichtung nach einem der Ansprüche 3 bis 5, wobei im Kanal Rippen (34) ausgebildet sind, deren Längsrichtung in Richtung des Kanals verlaufen.

7. Vorrichtung nach einem der vorangegangenen Ansprüche, wobei in beiden Teilelementen (10, 12) jeweils zumindest eine Ausnehmung (24, 30) vorgesehen ist, die zusammen den zumindest einen Hohlraum (32) bilden.

8. Vorrichtung nach Anspruch 7, wobei die Verbindungsflächen (22, 28) im wesentlichen in einer Verbindungsebene liegen und die Ausnehmungen (24, 30) in den beiden Teilelementen symmetrisch bezüglich der Verbindungsebene ausgebildet sind.

9. Vorrichtung nach einem der vorangegangenen Ansprüche, wobei an der Anlagefläche (20) zumindest teilweise eine elektrisch leitfähige erste Abschirmschicht (18) angeordnet ist.

10. Vorrichtung nach einem der vorangegangenen Ansprüche, wobei das zweite Teilelement (12) zusätzlich eine Aussenfläche (36) aufweist, an der zumindest bereichsweise eine elektrisch leitfähige zweite Abschirmschicht (38) angeordnet ist.

11. Vorrichtung nach einem der vorangegangenen Ansprüche, wobei das zweite Teilelement (12) eine Aussenfläche (36) aufweist, an die ein integriertes Heizelement (40) angeordnet und/oder ein externes Heizelement anbringbar ist.

12. Verfahren zur Herstellung einer Vorrichtung zum Temperieren eines Substrats (S) umfassend folgende Schritte in dieser Reihenfolge:
(a) Bereitstellen eines ersten Teilelements (10) mit einer Anlagefläche (20) und einer ersten Verbindungsfläche (22) und eines zweiten Teilelements (12) mit einer zweiten Verbindungsfläche (28), wobei zumindest eines der beiden Teilelemente (10, 12) Keramikmaterial umfasst;
(b) Ausbilden zumindest einer Ausnehmung (24, 30) in zumindest einer der beiden Verbindungsflächen (22, 28);
(c) Verbinden der ersten Verbindungsfläche (22) des ersten Teilelements (10) mit der zweiten Verbindungfläche (28) des zweiten Teilelements (12) derart, dass die zumindest eine Ausnehmung (24, 30) einen Hohlraum (32) in der Vorrichtung bildet, wobei zumindest eine Anschlussöffnung (48) ausgebildet wird, über die ein Temperierfluidzu- und/oder -abfluss zu und/oder von dem zumindest einen Hohlraum (32) ermöglicht wird; und
(d) Anordnen an zumindest einer der beiden Verbindungsflächen (22, 28) eine elektrisch leitfähige Verbindungsschicht (26), die vorzugsweise Nickel oder Kupfer umfasst.

13. Verfahren nach Anspruch 12, wobei der Schritt (c) des Verbindens der beiden Teilelemente (10, 12) Hartlöten umfasst.

14. Verfahren nach Anspruch 12 oder 13, wobei der Schritt (a) des Bereitstellens des ersten (10) und zweiten Teilelements (12) einen Schritt des Formens des ersten (10) und/oder zweiten Teilelements (12) als einen ersten und/oder einen zweiten Grünling aus Keramikmaterial umfasst.

15. Verfahren nach Anspruch 14, welches zusätzlich einen Schritt des Brennens des ersten und/oder zweiten als Grünling ausgebildeten Teilelements umfasst, wobei der Schritt (b) des Ausbildens der zumindest einen Ausnehmung (24, 30) vor dem Schritt des Brennens des entsprechenden Teilelements erfolgt, in dem die Ausnehmung (24, 30) ausgebildet wird.

16. Verfahren nach einem der Ansprüche 12 bis 15, welches zusätzlich einen Schritt des Ausbildens zumindest einer ersten elektrisch leitfähigen Abschirmschicht (18) an der Anlagefläche (20) und/oder einer zweiten elektrisch leitfähigen Abschimschicht (38) an einer Außenfläche (36) des zweiten Teilelements (12) umfasst.

17. Verfahren zum Temperieren eines Substrats (S) umfassend die Schritte:
- Bereitstellen einer Vorrichtung zum Temperieren eines Substrats gemäß einem der Ansprüche 1 bis 11;
- Anordnen des Substrats (S) zumindest teilweise an der Anlagefläche (20);
- Zuführen und/oder Abführen eines Fuids zu und/oder von dem zumindest einen Hohlraum (32) über die zumindest eine erste Anschlussöffnung (48).

18. Verfahren nach Anspruch 17, wobei das Fluid über die zumindest eine erste Anschlussöffnung (48) zu dem zumindest einen Hohlraum (32) zugeführt und über die zumindest eine zweite Anschlussöffnung (52) von dem zumindest einen Hohlraum (32) abgeführt wird.

19. Verfahren nach Anspruch 17 oder 18, wobei die Temperatur und/oder die Flussrate des zugeführten Fluids zur Steuerung bzw. Regelung der Temperatur des Substrats (S) verändert wird.

20. Verfahren nach einem der Ansprüche 17 bis 19, wobei in der Anlagefläche (20) Vakuumrillen ausgebildet sind und das Verfahren zusätzlich einen Schritt des Ansaugens des Substrats (S) mittels der Vakuumrillen umfasst.

21. Verfahren nach einem der Ansprüche 17 bis 20, wobei eine Vorrichtung gemäß einem der Ansprüche 1 bis 12 und den Ansprüchen 9 bis 11 bereitgestellt wird und wobei
- die erste Abschirmschicht (18) mit Force-Potential,
- die zweite Abschirmschicht (38) mit Shield-Potential und
- die Verbindungsschicht (26) mit Guard-Potential beaufschlagt wird.

22. Verfahren nach einem der Ansprüche 17 bis 21, wobei an einer Aussenfläche (36) des zweiten Teilelements (12) ein Heizelement (40) angeordnet ist und eine Steuerung bzw. Regelung der Temperatur des Substrats (S) eine Steuerung bzw. Regelung der Temperatur und/oder der Heizleistung des Heizelements (40) umfasst.

## Claims

1. A device for tempering a substrate (S), comprising:
- a first subcomponent (10) comprising an abutment face (20) for abutting on the substrate (S) and a first joining surface (22), and
- a second subcomponent (12) comprising a second joining surface (28) via which it is abutting at least partially on the first joining surface (22) of the first subcomponent (10),
wherein at least one of the two subcomponents (10, 12) comprises ceramic material,
at least one of the two joining surfaces (22, 28) is provided with at least one recess (24, 30) defining at least one cavity (32) in the device, and
at least one connecting port (48) is provided, enabling at least one of a tempering fluid inflow and outflow to and/or from the at least one cavity (32),
wherein an electrically conductive connection layer (26) is arranged at at least one of the two joining surfaces (22, 28), which preferably comprises nickel or copper.

2. The device according to claim 1, wherein at least one second connection port (52) is provided, through which at least one of a fluid inflow and outflow to and/or from the at least one cavity (32) is enabled.

3. The device according to claim 2, wherein the cavity (32) forms at least a continuous channel between the first (48) and the second connection port (52).

4. The device according to claim 3, wherein the at least one continuous channel extends in a substantially meandering shape.

5. The device according to claim 3 or 4, wherein the continuous channel is arranged such that a fluid passage to the second connection port through the channel from the first connection port occurs according to the counter flow principle.

6. The device according to any of claims 3 to 5, wherein ribs (34) are formed within the channel, with their longitudinal direction extending in the direction of the channel.

7. The device according to any of the preceding claims, wherein at least one recess (24, 30) is provided in both subcomponents (10, 12) forming at least one cavity (32) in combination.

8. The device according to claim 7, wherein the joining surfaces (22, 28) essentially lie in one joining plane and the recesses (24, 30) are formed symmetrically in respect to the joining plane in both subcomponents.

9. The device according to any of the preceding claims, wherein an electrically conductive screen layer (18) is arranged at least partially at the abutment face (20).

10. The device according to any of the preceding claims, wherein the second subcomponent (12) additionally comprises an outer surface (36), at which at least in sections an electrically conductive second screen layer (38) is arranged.

11. The device according to any of the preceding claims, wherein the second subcomponent (12) comprises an outer surface (36), at which an integrated heating element (40) is arranged and/or an external heating element can be attached.

12. A method for producing a device for tempering a substrate (S), comprising the following steps in this order:
(a) providing a first subcomponent (10) having an abutment face (20) and a first joining surface (22) and a second subcomponent (12) having a second joining surface (28), wherein at least one of the two subcomponents (10, 12) comprises ceramic material;
(b) forming at at least one recess (24, 30) in least one of the two joining surfaces (22, 28), and
(c) joining the first joining surface (22) of the first subcomponent (10) to the second joining surface (28) of the second subcomponent (12) such that the at least one recess (24, 30) forms a cavity (32) within the device, wherein at least one connecting port (48) is formed, enabling at least one of a tempering fluid inflow and outflow to and/or from the at least one cavity (32); and
(d) arranging an electrically conductive connection layer (26) preferably comprising nickel or copper at at least one of the two joining surfaces (22, 28).

13. The method according to claim 12, wherein the joining step (c) of both subcomponents (10, 12) comprises brazing.

14. The method according to claim 12 or 13, wherein the step (a) of providing the first (10) and second subcomponent (12) comprises a step of moulding the first (10) and/or second subcomponent (12) as a first and/or a second green body from ceramic material.

15. The method according to claim 14, comprising an additional step of baking the first and/or second subcomponent formed as a green body, wherein step (b) of forming the at least one recess (24, 30) is performed before the step of burning the corresponding subcomponent having formed the recess (24, 30).

16. The method according to any of claims 12 to 15, comprising an additional step of forming at least one electrically conductive screen layer (18) at the abutment face (20) and/or at least one second electrically conductive screen layer (38) at an outer surface (36) of the second subcomponent (12).

17. The method for tempering a substrate (S) comprising the steps of:
- providing a device for tempering a substrate according to any of claims 1 to 11;
- arranging the substrate (S) at least partially at the abutment face (20);
- supplying and/or discharging a fluid to and/or from the at least one cavity (32) through the at least one connection port (48).

18. The method according to claim 17, wherein the fluid is supplied to the at least one cavity (32) through the at least one first connection port (48) and is discharged from the at least one cavity (32) through the at least one second connection port (52).

19. The method according to claim 17 or 18, wherein the temperature and/or the flow rate of the supplied fluid is changed for controlling the temperature of the substrate (S).

20. The method according to any of claims 17 to 19, wherein vacuum grooves are formed in the abutment face (20) and the method additionally comprises a step of suctioning the substrate (S) by means of the vacuum grooves.

21. The method according to any of claims 17 to 20, wherein a device according to any of claims 1 to 12 and claims 9 to 11 is provided and wherein
- the first screen layer (18) is charged with a force potential,
- the second screen layer (38) is charge with a shield potential and
- the connection layer (26) is charged with a guard potential.

22. The method according to any of claims 17 to 21, wherein a heating element (40) is arranged at an outer surface (36) of the second subcomponent (12), a temperature control of the substrate (S) comprising a control of the temperature and/or the heating power of the heating element (40).

## Revendications

1. Dispositif pour réguler la température d'un substrat (S) comprenant :
- un premier élément partiel (10) qui présente une surface de départ (20) adjacente au substrat (S) ainsi qu'une première surface de jonction (22) et
- un second élément partiel (12), qui présente une seconde surface de jonction (28) qui est adjacente au moins en partie à la première surface de jonction (22) du premier élément partiel (10),
dans lequel au moins un des deux éléments partiels (10, 12) comprend de la céramique,
dans lequel est prévu au moins dans une des surfaces de jonction (22, 28) au moins un creux (24, 30), qui définit au moins une cavité (32) dans le dispositif, et
dans lequel est prévue au moins une première ouverture de raccordement (48), qui permet une alimentation et/ou une évacuation du liquide de régulation vers et/ou à partir d'au moins une cavité (32),
dans lequel au moins une des deux surfaces de jonction (22, 28) est recouverte d'une couche de jonction conductrice de l'électricité (26) qui comprend de préférence du nickel ou du cuivre.

2. Dispositif selon la revendication 1, dans lequel au moins une deuxième ouverture de raccordement (52) supplémentaire est prévue, par laquelle une alimentation et/ou une évacuation de fluide à partir de et/ou vers une cavité (32) est possible.

3. Dispositif selon la revendication 2, dans lequel la cavité (32) forme au moins un canal communiquant entre la première (48) et la deuxième ouverture de raccordement (52).

4. Dispositif selon la revendication 3, dans lequel au moins un canal communiquant serpente pour l'essentiel en décrivant des méandres.

5. Dispositif selon la revendication 3 ou 4, dans lequel le canal communiquant est orienté de telle sorte qu'un passage de liquide s'opère de la première ouverture de raccordement à la seconde par le biais du canal, pour l'essentiel selon le principe de contre-courant.

6. Dispositif selon l'une quelconque des revendications3 à 5, dans lequel des nervures (34) sont formées dans le canal, dont l'orientation longitudinale s'inscrit dans la direction du canal.

7. Dispositif selon l'une quelconque des revendications précédentes, dans lequel au moins un creux (24, 30) est prévu à chaque fois dans les éléments partiels (10, 12), qui constituent ensemble au moins une cavité (32).

8. Dispositif selon la revendication 7, dans lequel les surfaces de jonction (22, 28) se trouvent pour l'essentiel dans un niveau de jonction et les creux (24, 30) des deux éléments partiels sont organisés symétriquement par rapport au niveau de jonction.

9. Dispositif selon l'une quelconque des revendications précédentes, dans lequel au moins en partie une première gaine de blindage (18) conductrice de l'électricité est placée au niveau de surface de départ (20).

10. Dispositif selon l'une quelconque des revendications précédentes, dans lequel le second élément partiel (12) présente en plus une surface externe (36) sur laquelle est placée au moins partiellement une seconde gaine de blindage conductrice (38).

11. Dispositif selon l'une quelconque des revendications précédentes, dans lequel le second élément partiel (12) présente une surface externe (36) sur laquelle est placé un élément thermique intégré (40) et/ou sur laquelle un élément thermique externe peut être ajouté.

12. Procédé de fabrication d'un dispositif pour réguler la température d'un substrat (S) comprenant les étapes suivantes selon la séquence reprise ci-dessous :
a. Mise à disposition d'un premier élément partiel (10) avec une surface de départ (20) et une première surface de jonction (22), et un second élément partiel (12) avec une seconde surface de jonction (28), dans lequel au moins un des deux éléments partiels (10, 12) comprend de la céramique;
b. Création d'au moins un creux (24, 30) au moins dans une des deux surfaces de jonction (22, 28);
c. Jonction de la première surface de jonction (22) du premier élément partiel (10) avec la seconde surface de jonction (28) du second élément partiel (12) de telle sorte que qu'elle forme au moins un creux (24, 30) qui constitue une cavité (32) dans le dispositif, dans laquelle au moins une ouverture de raccordement (48) est formée, qui permet une alimentation et/ou une évacuation du liquide de régulation vers et/ou d'au moins une cavité (32) ; et
d. Placement sur au moins l'une des deux surfaces de jonction (22, 28) d'une couche de jonction conductrice de l'électricité (26) qui comprend de préférence du nickel ou du cuivre.

13. Procédé selon la revendication 12, dans lequel l'étape (c) de la jonction des deux éléments partiels (10, 12) comprend un brasage.

14. Procédé selon la revendication 12 ou 13, dans lequel l'étape (a) de la mise à disposition du premier (10) et du second élément partiel (12) comprend une étape du façonnage du premier (10) et/ou du second élément partiel (12) comme un premier et/ou un second élément cru en céramique.

15. Procédé selon la revendication 14, qui comprend en outre une étape de cuisson du premier et/ou du second élément partiel façonné en élément cru, dans lequel l'étape (b) de la formation d'au moins un creux (24, 30) intervient avant l'étape de la cuisson de l'élément partiel correspondant, dans lequel un creux (24, 30) est formé.

16. Procédé selon l'une quelconque des revendications 12 à 15, qui comprend en plus une étape de formation d'au moins une première gaine de blindage conductrice (18) sur la surface de départ (20) et/ou une seconde gaine de blindage conductrice (38) sur une surface extérieure (36) du second élément partiel (12).

17. Procédé pour réguler la température d'un substrat (S) comprenant les étapes suivantes :
- mise à disposition d'un dispositif pour réguler la température d'un substrat selon l'une quelconque des revendications 1 à 11 ;
- placement du substrat (S) au moins en partie sur la surface de départ (20) ;
- alimentation et/ou évacuation d'un liquide vers et/ou à partir d'au moins une cavité (32) via au moins une première ouverture de raccordement (48).

18. Procédé selon la revendication 17, dans lequel le fluide est amené via au moins une ouverture de raccordement (48) à au moins une cavité (32) et est évacué via au moins une seconde ouverture de raccordement (52) d'au moins une cavité (32).

19. Procédé selon la revendication 17 ou 18, dans lequel la température et/ou le débit du fluide amené pour contrôler et/ou régler la température du substrat (S) est modifié.

20. Procédé selon l'une quelconque des revendications 17 à 19, dans lequel des stries de vide sont formées dans la surface de départ (20), et le procédé comprend en plus une étape d'aspiration du substrat (S) à l'aide des stries de vide.

21. Procédé selon l'une quelconque des revendications 17 à 20, dans lequel un dispositif selon l'une quelconque des revendications 1 à 12 et 9 à 11 est mis à disposition dans lequel
- la première gaine de blindage (18) est alimentée en potentiel de force ;
- la seconde gaine de blindage (38) est alimentée en potentiel de blindage ;
- la couche de jonction (26) est alimentée en potentiel de garde.

22. Procédé selon l'une quelconque des revendications 17 à 21, dans lequel un élément thermique (40) est placé sur la surface extérieure (36) du second élément partiel (12) et une commande ou réglage de la température du substrat (S) comprend un contrôle et/ou un réglage de la température et/ou de la puissance calorifique de l'élément thermique (40).
